# EUROPEAN PATENT APPLICATION

(11) **EP 4 737 916 A1**
(43) Date of publication of application: **06.05.2026**
(21) Application number: 24861526.2
(22) Date of filing: 07.05.2024
(51) Int. Cl.: G01R 19/25, G01R 1/20, G01R 15/20

(54) **CURRENT SAMPLING DEVICE, SYSTEM, AND CIRCUIT, AND VEHICLE**

(30) Priority: 08.09.2023 CN 202322442551 U
(71) Applicant: Contemporary Amperex Technology Co., Limited, Ningde, Fujian 352100 (CN); Contemporary Amperex Runzhi Software Technology Limited, Ningde, Fujian 352100 (CN)
(72) Inventor: WU, Zhihong, Ningde, Fujian 352100 (CN); WANG, Xingchang, Ningde, Fujian 352100 (CN)
(74) Representative: Lorenz Seidler Gossel Part. mbB
(86) International application number: PCT/CN2024/091369
(87) International publication number: WO 2025/050677

(57) **Abstract**

Embodiments of the present application provide a current sampling apparatus, a current sampling system, a current sampling circuit, and a vehicle. The apparatus includes: a shunt, the shunt including a plurality of conductive connection members and at least one signal conversion member, where the plurality of conductive connection members are arranged sequentially, and the at least one signal conversion member is disposed in at least one conductive connection member group, the conductive connection member group including two adjacent conductive connection members; a circuit board, the circuit board being disposed on one side surface of the shunt, and the at least one signal conversion member being connected to the circuit board; and a signal measurement assembly, the signal measurement assembly being disposed on any one of the plurality of conductive connection members, and the signal measurement assembly being connected to the circuit board, where the signal measurement assembly is provided with a positive electrode sampling point and a negative electrode sampling point, the positive electrode sampling point and the negative electrode sampling point being disposed on side surfaces of the conductive connection member, respectively.

## Description

### CROSS-REFERENCE TO RELATED APPLICATION

The present application claims priority to Chinese Patent Application No. 202322442551.0, entitled "CURRENT SAMPLING APPARATUS, SYSTEM, AND CIRCUIT, AND VEHICLE", filed on September 8, 2023, the entire contents of which are incorporated herein by reference.

### TECHNICAL FIELD

The present application relates to the technical field of battery management systems, and in particular, to a current sampling apparatus, a current sampling system, a current sampling circuit, and a vehicle.

### BACKGROUND

As the new energy vehicle industry continues to develop rapidly, the detection of battery management systems is particularly important, especially the real-time monitoring of current data of a vehicle during driving and charging processes. Currently, to ensure the accuracy in current detection, it is typically necessary to use different components for primary sampling and redundant sampling, resulting in large structural dimensions of the entire current sampling apparatus, which is not conducive to miniaturization.

### SUMMARY

Embodiments of the present application provide a current sampling apparatus, a current sampling system, a current sampling circuit, and a vehicle, to solve the technical problem of the large dimensions of the current sampling apparatus, which is not conducive to miniaturization.

In a first aspect, embodiments of the present application provide a current sampling apparatus, including:
a shunt comprising a plurality of conductive connection members and at least one signal conversion member, wherein the plurality of conductive connection members are arranged sequentially, and the at least one signal conversion member is disposed in at least one conductive connection member group, the conductive connection member group comprising two adjacent conductive connection members;
a circuit board disposed on one side surface of the shunt, and the at least one signal conversion member being connected to the circuit board; and
a signal measurement assembly disposed on any one of the plurality of conductive connection members, and the signal measurement assembly being connected to the circuit board, wherein the signal measurement assembly is provided with a positive electrode sampling point and a negative electrode sampling point, the positive electrode sampling point and the negative electrode sampling point being disposed on side surfaces of the conductive connection member, respectively.

In this embodiment, the shunt and the signal measurement assembly are integrally designed, which achieves multi-channel sampling while reducing the structural dimensions, thereby facilitating miniaturization. Meanwhile, sampling is performed through the signal measurement assembly without the need for a magnetic core, which, on the one hand, further reduces the structural dimensions, and on the other hand, avoids the risk of affecting sampling accuracy due to magnetic core saturation.

In some embodiments, the positive electrode sampling point and the negative electrode sampling point are disposed on two opposite side surfaces of the conductive connection member, respectively.

In this embodiment, by disposing the positive electrode sampling point and the negative electrode sampling point on two opposite side surfaces of the conductive connection member, respectively, current signals in opposite directions can be collected, thereby achieving differential sampling and further improving the sampling accuracy.

In some embodiments, the plurality of conductive connection members are disposed spaced apart from each other, and the signal conversion member is located within at least a portion of a spacing between two adjacent ones of the conductive connection members.

In this embodiment, by disposing the plurality of conductive connection members spaced apart from each other and locating the signal conversion member within at least a portion of the spacing between two adjacent ones of the conductive connection members, mutual interference between signals generated on the conductive connection members can be reduced, resulting in higher sampling accuracy.

In some embodiments, the signal conversion member is disposed between every two adjacent ones of the conductive connection members.

In this embodiment, by disposing the signal conversion member between every two adjacent ones of the conductive connection members, that is, disposing one signal conversion member between every two adjacent conductive connection members, the structure of the shunt module can be made more compact, further reducing the structural dimensions and facilitating miniaturization.

In some embodiments, the circuit board includes:
a first sub-circuit board connected to the at least one signal conversion member; and
a second sub-circuit board electrically connected to the first sub-circuit board and connected to the signal measurement assembly.

In this embodiment, the integrated design of the shunt and the signal measurement assembly is implemented through different circuit boards, making the structural arrangement of the current sampling apparatus made more reasonable and more conductive to miniaturization requirements.

In some embodiments, at least one side of the conductive connection member provided with the signal measurement assembly is provided with a notch, and the position of the notch corresponds to the position of the signal measurement assembly.

In this embodiment, by providing a notch at the position of the conductive connection member that corresponds to the signal measurement assembly, the magnetically induced current at this location is made more concentrated, thereby improving the sampling accuracy of the signal measurement assembly.

In some embodiments, the notch covers a projection of the signal measurement assembly on the side surface of the conductive connection member that is provided with the notch.

In this embodiment, by configuring the notch to cover the projection of the signal measurement assembly on the side surface of the conductive connection member that is provided with the notch, the ability of the notch to concentrate the magnetically induced current can be enhanced, thereby further improving the sampling accuracy of the signal measurement assembly.

In some embodiments, the current sampling apparatus further includes:
at least one temperature sensor disposed in correspondence with the at least one signal conversion member, the at least one temperature sensor being connected to the circuit board.

In this embodiment, the temperature sensor can collect the temperature of the signal conversion member to facilitate subsequent compensation for the temperature drift of the signal conversion member, thereby improving the sampling accuracy of the signal conversion member and thus enhancing the current detection accuracy.

In some embodiments, the current sampling apparatus further includes:
a calibration identifier, the calibration identifier being disposed on the circuit board.

In this embodiment, the initial resistance value of the shunt and the temperature compensation coefficient may be calibrated by means of the calibration identifier, thereby avoiding subsequent sampling deviations and improving current sampling accuracy.

In some embodiments, the circuit board is provided with a signal transmission member, the signal transmission member being electrically connected to the shunt and the signal measurement assembly, and the signal transmission member being configured to transmit electrical signals generated on the shunt and the signal measurement assembly.

In this embodiment, by disposing the signal transmission member on the circuit board, the transmission of electrical signals generated on the shunt and the signal measurement assembly can be facilitated.

In some embodiments, the signal measurement assembly includes at least one of a Hall effect component, a shunt component, or a magnetoresistive effect component.

In this embodiment, by configuring the signal measurement assembly to include at least one of a Hall effect component, a shunt component, or a magnetoresistive effect component, the implementation of the signal measurement assembly is made more flexible and diverse, thereby increasing the application scenarios of the current sampling apparatus.

In a second aspect, embodiments of the present application provide a current sampling system, including:
a battery and a sampling board;
and the current sampling apparatus according to the first aspect;
where the battery and the sampling board are separately connected to the current sampling apparatus.

In this embodiment, the current sampling system may include the aforementioned current sampling apparatus. Consequently, the shunt and the signal measurement assembly are integrally designed, which achieves multi-channel sampling while reducing the structural dimensions, thereby facilitating miniaturization. Meanwhile, sampling is performed through the signal measurement assembly without the need for a magnetic core, which, on the one hand, further reduces the structural dimensions, and on the other hand, avoids the risk of affecting sampling accuracy due to magnetic core saturation.

In a third aspect, embodiments of the present application provide a current sampling circuit, including:
at least one shunt sampling module, the shunt sampling module being disposed in correspondence with at least one signal conversion member in the current sampling apparatus of the first aspect;
a signal sampling module, the signal sampling module corresponding to a signal measurement assembly in the current sampling apparatus of the first aspect; and
a main control module, the main control module being configured to be separately connected to the at least one shunt sampling module and the signal sampling module.

In this embodiment, the shunt and the signal measurement assembly are integrally designed, which achieves multi-channel sampling while reducing the structural dimensions, thereby facilitating miniaturization. Meanwhile, sampling is performed through the signal measurement assembly without the need for a magnetic core, which, on the one hand, further reduces the structural dimensions, and on the other hand, avoids the risk of affecting sampling accuracy due to magnetic core saturation.

In some embodiments, the signal sampling module includes a storage sub-module, the storage sub-module being configured to back up calibration data.

In this embodiment, the storage sub-module may be configured to back up calibration data, thereby further improving the sampling accuracy of the signal measurement assembly.

In some embodiments, the signal sampling module further includes a signal modulation sub-module, the signal modulation sub-module being configured to amplify and shape a voltage signal generated by the signal measurement assembly.

In this embodiment, the signal modulation sub-module may be configured to amplify and shape the voltage signal generated by the signal measurement assembly, thereby further improving the sampling accuracy of the signal measurement assembly.

In some embodiments, the signal sampling module further includes an over current detection sub-module, the over current detection sub-module being configured to perform over current detection on a current signal sampled by the signal sampling module.

In this embodiment, the over current detection sub-module can effectively detect whether there is an over current risk, thereby reducing the risk of thermal runaway in the battery pack.

In a fifth aspect, embodiments of the present application provide a vehicle, including the current sampling system according to the second aspect or the current sampling circuit according to the third aspect.

The foregoing description is merely an overview of the technical solutions in the present application. In order that technical means of the present application can be understood more clearly so that the technical means can be implemented according to content of the specification, and in order that the foregoing and other objectives, features, and advantages of the present application can be understood more clearly, specific embodiments of the present application are described below.

### BRIEF DESCRIPTION OF DRAWINGS

In order to illustrate the technical solutions of the embodiments of the present application more clearly, the drawings required in the embodiments of the present application are briefly introduced below. Obviously, the drawings described below are only some embodiments of the present application. For those of ordinary skill in the art, other drawings can also be obtained according to these drawings without any creative effort.
FIG. 1 is a structural schematic diagram of a current sampling apparatus provided in an embodiment of the present application;
FIG. 2 is a structural schematic diagram of a shunt provided in an embodiment of the present application;
FIG. 3 is a cross-sectional schematic diagram of a current sampling apparatus provided in an embodiment of the present application;
FIG. 4 is a partial schematic diagram of the signal measurement assembly in FIG. 3;
FIG. 5 is a structural schematic diagram of a current sampling system provided in an embodiment of the present application; and
FIG. 6 is a structural schematic diagram of a current sampling circuit provided in an embodiment of the present application.

### Reference numerals:

100: current sampling apparatus; 101: battery; 102: sampling board;
1: shunt; 11: conductive connection member; 111: notch; 12: signal conversion member; 2: circuit board; 21: signal transmission member; 22: first sub-circuit board; 23: second sub-circuit board; 3: signal measurement assembly; 4: temperature sensor; 5: calibration identifier.

In the drawings, the drawings are not drawn to actual scale.

### DETAILED DESCRIPTION

Embodiments of the present application are described in further detail below in conjunction with the drawings and embodiments. The following detailed description of the embodiments and the drawings are configured to illustrate the principles of the present application by way of example, but should not be configured to limit the scope of the present application, that is, the present application is not limited to the described embodiments.

In the description of the present application, it should be noted that, unless otherwise stated, "a plurality of" means two or more. The orientation or positional relationships indicated by the terms "upper", "lower", "left", "right", "inner" and "outer" are only for facilitating the description of the present application and simplifying the description, rather than indicating or implying that the apparatus or element referred to must have a particular orientation or be constructed and operated in a particular orientation, and therefore will not be interpreted as limiting the present application. In addition, the terms "first", "second" and "third" are used for descriptive purposes only, and cannot be construed as indicating or implying relative importance. "Perpendicular" is not strictly perpendicular, but within the allowable range of errors. "Parallel" is not strictly parallel, but within the allowable range of errors.

Orientation words appearing in the following description are all directions shown in the drawings, and do not limit the specific structure of the present application. In the description of the present application, it should also be noted that, unless otherwise expressly specified and limited, the terms "mount," "connected," and "connecting" should be broadly understood, for example, they may be a fixed connection or a detachable connection or be an integrated connection; or may be a direct connection or an indirect connection through an intermediate medium. For those of ordinary skill in the art, the specific meanings of the above terms in the present application may be understood according to specific circumstances.

In the related art, current sampling apparatuses in current detection typically require the use of both a shunt and a Hall sensor for primary sampling and redundant sampling. However, the shunt and the Hall sensor are generally of separate structures, resulting in the current sampling apparatus often having large structural dimensions, which is not conducive to miniaturization. Meanwhile, Hall sensors typically perform vertical sampling through a magnetic core. The magnetic core requires different dimensions depending on the charging and discharging current, particularly requiring larger dimensions under high current conditions, which is even less conducive to miniaturization. Additionally, there is a risk of magnetic core saturation, which affects the current sampling accuracy.

Based on the aforementioned problems, the applicant has made improvements to the structure of the current sampling apparatus. The technical solutions described in the embodiments of the present application are applicable to current sampling apparatuses, current sampling systems including such current sampling apparatuses, current sampling circuits applied to such current sampling systems, battery management systems including such current sampling apparatuses, and vehicles using such battery management systems.

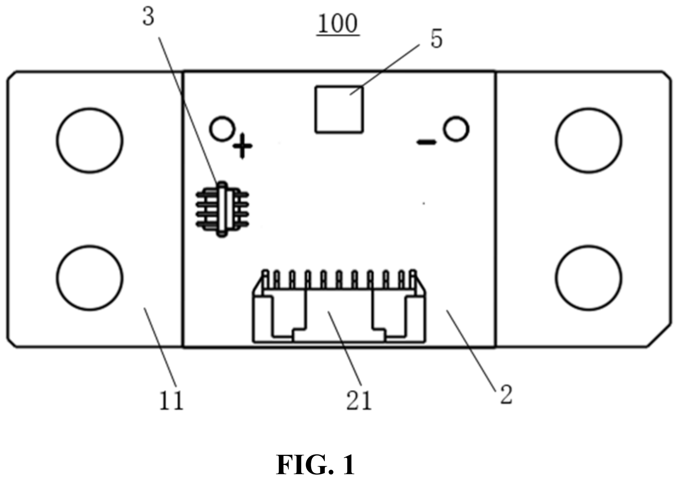

Please refer to FIG. 1 to FIG. 4. An embodiment of the present application provides a current sampling apparatus 100, including:
a shunt 1, including a plurality of conductive connection members 11 and at least one signal conversion member 12, where the plurality of conductive connection members 11 are arranged sequentially, and the at least one signal conversion member 12 is disposed in at least one conductive connection member group, the conductive connection member group including two adjacent conductive connection members 11;
a circuit board 2, the circuit board 2 being disposed on one side surface of the shunt 1, and the at least one signal conversion member 12 being connected to the circuit board 2; and
a signal measurement assembly 3, the signal measurement assembly 3 being disposed on the conductive connection member 11, and connected to the circuit board 2, where the signal measurement assembly 3 is provided with a positive electrode sampling point and a negative electrode sampling point, the positive electrode sampling point and the negative electrode sampling point being disposed on two opposite side surfaces of the conductive connection member 11, respectively.

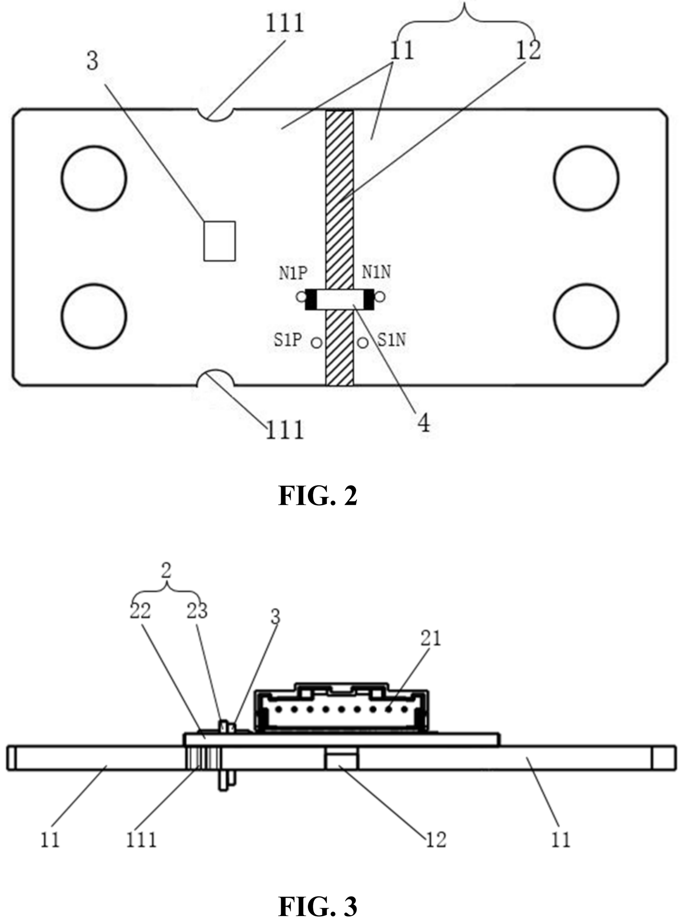

In this embodiment, the shunt 1 may include a plurality of conductive connection members 11 and at least one signal conversion member 12. Herein, the number of the signal conversion member(s) 12 may be one or a plurality. Taking the number of the signal conversion member(s) 12 being one as an example, as shown in FIG. 2, the composition of the shunt 1 from left to right may be: the conductive connection member 11 - the signal conversion member 12 - the conductive connection member 11.

The aforementioned plurality of conductive connection members 11 being arranged sequentially may mean that any two conductive connection members 11 among the plurality of conductive connection members 11 are at least partially adjacent, or alternatively, the conductive connection members 11 may be disposed spaced apart from each other.

The aforementioned at least one signal conversion member 12 being disposed between at least one conductive connection member group may mean that adjacent conductive connection members among the plurality of conductive connection members form at least one conductive connection group, and within at least a portion of the at least one conductive connection group, at least one signal conversion member 12 is provided.

For example, assuming that the number of the aforementioned conductive connection members 11 is four and the number of the signal conversion members 12 is two, the four conductive connection members 11 may form three conductive connection groups. The two signal conversion members may be disposed within one conductive connection group, or alternatively, may be disposed within two conductive connection groups.

The aforementioned two adjacent conductive connection members 11 may mean that the two conductive connection members 11 are proximate in their arrangement positions. For example, the two conductive connection members 11 may be at least partially adjacent, or alternatively, there may be a common spacing between the two conductive connection members 11.

It should be noted that, in the case where there are two adjacent conductive connection members 11 among the aforementioned plurality of conductive connection members 11, the adjacent conductive connection members 11 may be insulated from each other. The aforementioned signal conversion member 12 being disposed between the adjacent conductive connection members 11 may mean that a partially hollowed-out region is also provided between the adjacent conductive connection members 11, and the signal conversion member 12 is embedded within this hollowed-out region.

The aforementioned signal conversion member 12 being disposed between two adjacent conductive connection members 11 may mean that the conductive connection member 11 and the signal conversion member 12 are fixedly connected and electrically conductive to each other. Specifically, the conductive connection member 11 and the signal conversion member 12 may be welded together by electron beam welding.

The signal conversion member 12 may be any component capable of converting a current signal from a battery pack into a voltage signal to facilitate subsequent current sampling. The signal conversion member 12 may be provided with sampling points. For example, as shown in FIG. 2, the signal conversion member 12 may include a sampling positive terminal S1P and a sampling negative terminal S1N.

The conductive connection member 11 may be any metal member possessing conductive properties. Specifically, the aforementioned conductive connection member 11 may be a copper busbar, and the copper busbar may be a flexible copper busbar or a rigid copper busbar. More specifically, the aforementioned conductive connection member 11 may be a copper bar (or, also referred to as a "flexible copper bar").

The dimensions of the conductive connection member 11 may be determined through thermal dissipation analysis using simulation software according to different currents of the battery pack, which is not specifically limited here.

As shown in FIG. 1, the current sampling apparatus 100 may further include a circuit board 2 and a signal measurement assembly 3. The circuit board 2 is disposed on one side surface of the shunt 1 and may cover at least one signal conversion member 12 and at least some conductive connection members 11 among the plurality of conductive connection members 11. The circuit board 2 may be welded together with the signal conversion member 12 and the conductive connection member 11 by means of vacuum reflow soldering.

As an example, the signal conversion member 12 may be soldered onto the circuit board 2 through a surface mounted technology (SMT) process to achieve an electrical connection, thereby facilitating subsequent signal transmission.

The circuit board 2 may be any board-shaped structure having connection circuits, where the connection circuits are configured to transmit electrical signals. Specifically, the circuit board 2 may be a rigid circuit board or may be a flexible circuit board, etc. The circuit board 2 may be configured for electrical connections between various components of the current sampling apparatus 100, simplifying assembly work, reducing wiring, achieving space-saving purposes, and reducing the structural dimensions, thereby facilitating miniaturization.

The signal measurement assembly 3 may be any assembly capable of measuring the collected electrical signals. For example, the aforementioned signal measurement assembly 3 may be a Hall effect component, and more specifically, may be a Hall chip, etc.

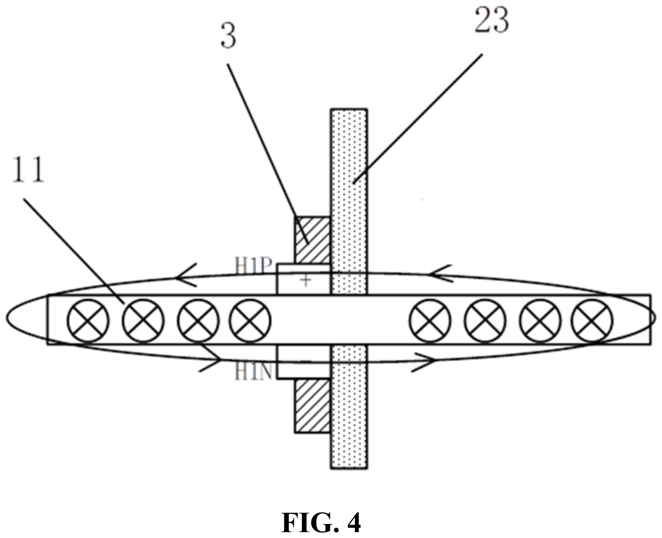

The signal measurement assembly 3 may be disposed on any conductive connection member 11 among the plurality of conductive connection members 11 and is electrically connected to the circuit board 2. As shown in FIG. 4, the signal measurement assembly 3 is provided with a positive electrode sampling point H1P and a negative electrode sampling point H1N. The positive electrode sampling point H1P and the negative electrode sampling point H1N are disposed on the side surfaces of the conductive connection member 11.

The aforementioned positive electrode sampling point H1P and negative electrode sampling point H1N being disposed on the side surfaces of the conductive connection member 11 may mean that they are disposed on the same side surface of the conductive connection member 11, or alternatively, may be disposed on adjacent side surfaces of the conductive connection member 11.

It is understandable that the signal measurement assembly 3 is spatially compact, is highly sensitive to magnetic fields parallel to its side surfaces, and is easy to integrate. Meanwhile, the signal measurement assembly 3 is typically made of amorphous magnetic material, and possesses high magnetic permeability and low magnetic hysteresis. It does not require a magnetic core, and thus can directly measure the current flowing in busbars or circuit board 2 traces under encapsulation. It is evident that using the signal measurement assembly 3 for current sampling further facilitates structural miniaturization.

It should be noted that the term "connection" mentioned in the present application may be understood as at least one of a connection in terms of a physical structure or an electrical connection. As an example, the aforementioned electrical connection between the signal measurement assembly 3 and the circuit board 2 may mean that the signal measurement assembly 3 is fixedly connected to the circuit board 2 and is electrically connected to the circuit board 2.

In this embodiment, the shunt 1 and the signal measurement assembly 3 are integrally designed, which achieves multi-channel sampling while reducing the structural dimensions, thereby facilitating miniaturization. Meanwhile, sampling is performed through the signal measurement assembly 3 without the need for a magnetic core, which, on the one hand, further reduces the structural dimensions, and on the other hand, avoids the risk of affecting sampling accuracy due to magnetic core saturation.

In some embodiments, the positive electrode sampling point H1P and the negative electrode sampling point H1N are disposed on two opposite side surfaces of the conductive connection member 11, respectively.

In this embodiment, by disposing the positive electrode sampling point H1P and the negative electrode sampling point H1N on two opposite side surfaces of the conductive connection member 11, respectively, current signals in opposite directions can be collected, thereby achieving differential sampling and further improving the sampling accuracy.

In some embodiments, the plurality of conductive connection members 11 are disposed spaced apart from each other, and the signal conversion member 12 is located within at least a portion of a spacing between two adjacent ones of the conductive connection members 11.

In this embodiment, by disposing the plurality of conductive connection members 11 spaced apart from each other and locating the signal conversion member 12 within at least a portion of the spacing between two adjacent ones of the conductive connection members 11, mutual interference between signals generated on the conductive connection members 11 can be reduced, resulting in higher sampling accuracy.

The aforementioned signal conversion member 12 may be disposed within a portion of the spacing between two adjacent conductive connection members 11; for example, the signal conversion member 12 occupies 1/4, 1/2, or 3/4 of the spacing between two adjacent conductive connection members; or, the aforementioned signal conversion member 12 may fill the spacing between two adjacent conductive connection members 11.

In some embodiments, the signal conversion member is disposed between every two adjacent ones of the conductive connection members.

In this embodiment, by disposing the signal conversion member between every two adjacent ones of the conductive connection members, that is, disposing one signal conversion member between every two adjacent conductive connection members, the structure of the shunt module can be made more compact, further reducing the structural dimensions and facilitating miniaturization.

The signal conversion member being disposed between every two adjacent conductive connection members 11 as described above may be understood as follows: in a case where the number of the aforementioned conductive connection members 11 is N, the number of the aforementioned signal conversion members 12 is N-1, where N is an integer greater than 1.

In some embodiments, the circuit board 2 includes:
a first sub-circuit board 22, the first sub-circuit board 22 being connected to the at least one signal conversion member 12; and
a second sub-circuit board 23, the second sub-circuit board being electrically connected to the first sub-circuit board 22 and being connected to the signal measurement assembly 3.

As shown in FIG. 3, the circuit board 2 may include a first sub-circuit board 22 and a second sub-circuit board 23, where the first sub-circuit board 22 may be disposed on one side surface of the shunt 1 and is connected to the at least one signal conversion member 12. In other words, the first sub-circuit board 22 may be parallel to the plane in which the plurality of conductive connection members 11 are located.

As shown in FIG. 4, the second sub-circuit board 23 may be electrically connected to the first sub-circuit board 22 and is connected to the signal measurement assembly 3. As mentioned above, the signal measurement assembly 3 generally has a positive electrode sampling point H1P and a negative electrode sampling point H1N located on two side surfaces of the conductive connection member 11, respectively; based on this, to better connect with the signal measurement assembly 3, the second sub-circuit board may be arranged perpendicular to the plane in which the conductive connection member 11 is located.

The aforementioned first sub-circuit board 22 and second sub-circuit board 23 may be formed by two regions on one integral circuit board; or, the aforementioned first sub-circuit board 22 and second sub-circuit board 23 may be two mutually independent circuit boards.

In this embodiment, based on the structural layout of the shunt 1 and the signal measurement assembly 3, an integrated design of the shunt 1 and the signal measurement assembly 3 can be implemented through different circuit boards 2, making the structural arrangement of the current sampling apparatus 100 more reasonable and more conducive to miniaturization requirements.

In some embodiments, at least one side surface of the conductive connection member 11 provided with the signal measurement assembly 3 is provided with a notch 111, and the position of the notch 111 corresponds to the position of the signal measurement assembly 3. Certainly, in addition to the conductive connection member 11 provided with the signal measurement assembly 3 being provided with a notch 111, other conductive connection members 11 may also be provided with notches 11, which is not limited herein.

As shown in FIG. 2 and FIG. 3, at the position corresponding to the signal measurement assembly 3, the conductive connection member 11 may be provided with a notch 111 on at least one of its sides; for example, notches 111 may be provided on both sides, such that the magnetic field at this location is relatively concentrated, thereby making the magnetically induced current more aggregated, such that the signal measurement assembly 3 can more accurately acquire the current signal.

That the position of the aforementioned notch 111 corresponds to the position of the signal measurement assembly 3 can be understood as: on the side surface of the conductive connection member 11 that is provided with the notch 111, the projection of the signal measurement assembly 3 at least partially overlaps with the notch 111.

In this embodiment, by providing a notch 111 at the position of the conductive connection member 11 that corresponds to the signal measurement assembly 3, the magnetically induced current at this location is made more concentrated, thereby improving the sampling accuracy of the signal measurement assembly 3.

In some embodiments, the notch 111 covers a projection of the signal measurement assembly 3 on the side surface of the conductive connection member 11 that is provided with the notch 111.

In this embodiment, by configuring the notch 111 to cover the projection of the signal measurement assembly 3 on the side surface of the conductive connection member 11 that is provided with the notch 111, the ability of the notch 111 to concentrate the magnetically induced current can be enhanced, thereby further improving the sampling accuracy of the signal measurement assembly 3.

In some embodiments, as shown in FIG. 2, the current sampling apparatus 100 further includes:
at least one temperature sensor 4, the at least one temperature sensor 4 being disposed in correspondence with the at least one signal conversion member 12, and the at least one temperature sensor 4 being connected to the circuit board 2.

In this embodiment, the aforementioned at least one temperature sensor 4 is disposed in correspondence with the at least one signal conversion member 12, and the number of the temperature sensors 4 is equal to the number of the signal conversion members 12; that is, one temperature sensor 4 may be disposed in correspondence with one signal conversion member 12. The temperature sensor 4 may be soldered onto the circuit board 2 via a surface mounted technology (SMT) process to achieve electrical connection, facilitating subsequent signal transmission.

The temperature sensor 4 being disposed in correspondence with the signal conversion member 12 as described above may be understood as follows: the temperature sensor 4 is configured only to acquire the temperature of the signal conversion member 12 corresponding to it, and the corresponding temperature sensor 4 and the signal conversion member 12 may have a relationship in their arrangement positions; for example, the temperature sensor 4 may be fixedly connected to the signal conversion member 12 corresponding to it; or, the corresponding temperature sensor 4 and the signal conversion member 12 may also have other association relationships, such as an electrical connection or being disposed opposite to and spaced apart from each other, and so on.

Taking the case where the numbers of both the signal conversion members 12 and the temperature sensors 4 are one as an example, as shown in FIG. 2, the temperature sensor 4 may be disposed in correspondence with the signal conversion member 12, and the temperature sensor 4 may be provided with a sampling positive terminal N1P and a sampling negative terminal N1N. The temperature sensor 4 may acquire the temperature of the signal conversion member 12 and transmit the temperature change on the signal conversion member 12 to the sampling board 102 via the sampling positive terminal N1P and the sampling negative terminal N1N of the temperature sensor 4, such that the sampling board 102 can perform compensation for temperature drift of the signal conversion member 12.

In this embodiment, the temperature sensor 4 can collect the temperature of the signal conversion member 12 to facilitate subsequent compensation for the temperature drift of the signal conversion member 12, thereby improving the sampling accuracy of the signal conversion member 12 and thus enhancing the current detection accuracy.

In some embodiments, the current sampling apparatus 100 further includes:
a calibration identifier 5, the calibration identifier 5 being disposed on the circuit board 2.

In this embodiment, the current sampling apparatus 100 may further include the calibration identifier 5 disposed on the circuit board 2, where the calibration identifier 5 may include a bar code, a QR code, or the like. The initial resistance values of the shunt 1 and the signal measurement assembly 3 and the temperature compensation coefficient may be calibrated to the sampling board 102 by scanning the calibration identifier 5.

In this embodiment, the initial resistance value of the shunt 1 and the temperature compensation coefficient may be calibrated by means of the calibration identifier 5, thereby avoiding subsequent sampling deviations and improving current sampling accuracy.

In some embodiments, the material of the N-1 signal conversion members 12 is any one of a manganin alloy, an iron-chromium-aluminum alloy, and a nickel-chromium alloy.

In this embodiment, the material of the signal conversion member 12 is any one of a manganin alloy, an iron-chromium-aluminum alloy, and a nickel-chromium alloy; for example, a manganin alloy may be used, which has characteristics such as high sensitivity, fast response, good linearity, and a small resistance temperature coefficient, and can effectively ensure the current sampling accuracy of the shunt 1.

In this embodiment, for the material of the signal conversion member 12, depending on actual requirements, any one of a manganin alloy, an iron-chromium-aluminum alloy, and a nickel-chromium alloy may be selected, and the shunt 1 has high flexibility, so as to meet more diverse needs.

In some embodiments, the circuit board 2 is provided with a signal transmission member 21, the signal transmission member 21 being electrically connected to the shunt 1 and the signal measurement assembly 3, and the signal transmission member 21 being configured to transmit electrical signals generated on the shunt 1 and the signal measurement assembly 3.

In this embodiment, by disposing the signal transmission member 21 on the circuit board 2, the transmission of electrical signals generated on the shunt 1 and the signal measurement assembly 3 can be facilitated.

The signal transmission member 21 may be soldered onto the circuit board 2 by means of SMT. Here, the signal transmission member 21 may be configured to transmit electrical signals generated on the shunt 1 and the signal measurement assembly 3 to the sampling board 102 via a wire harness to achieve the purpose of current sampling.

In some embodiments, the signal measurement assembly 3 includes at least one of a Hall effect component, a shunt component, or a magnetoresistive effect component.

In this embodiment, by configuring the signal measurement assembly 3 to include at least one of a Hall effect component, a shunt component, or a magnetoresistive effect component, the implementation of the signal measurement assembly is made more flexible and diverse, increasing the application scenarios of the current sampling apparatus.

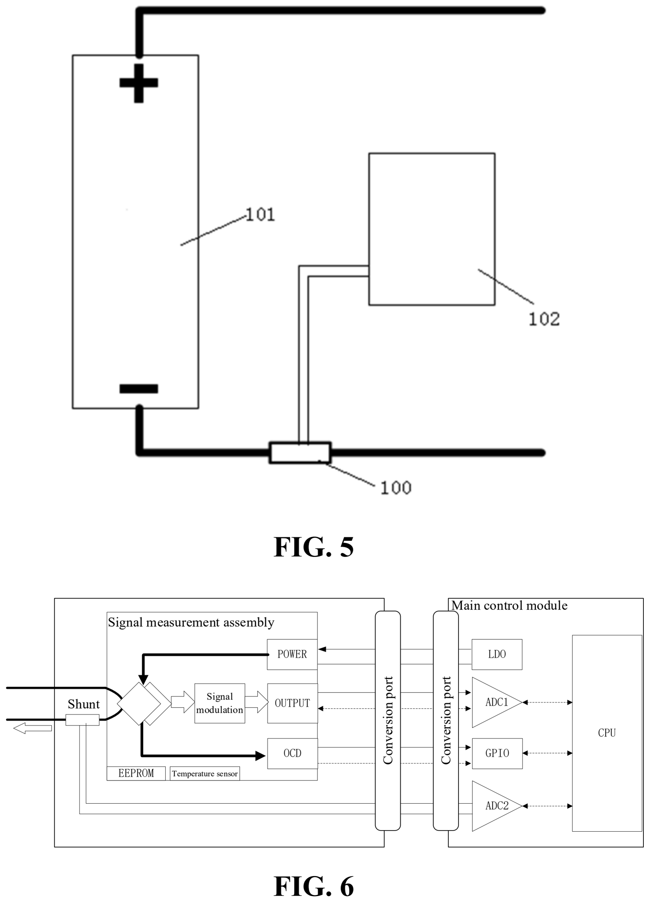

As shown in FIG. 5, embodiments of the present application further provide a current sampling system, including:
a battery 101 and a sampling board 102;
and the current sampling apparatus 100 described above;
where the battery 101 and the sampling board 102 are separately connected to the current sampling apparatus 100.

In this embodiment, as shown in FIG. 5, the current sampling system may include the battery 101, the sampling board 102, and the current sampling apparatus 100, where the battery 101 and the sampling board 102 may be separately connected to the current sampling apparatus 100, and the shunt 1 and the signal measurement assembly 3 in the current sampling apparatus 100 may separately perform multi-channel sampling on the current signal of the battery 101 and transmit it to the sampling board 102 to perform current detection, such that the state of the battery 101 can be analyzed.

In this embodiment, the current sampling system may include the aforementioned current sampling apparatus 100. Consequently, the shunt 1 and the signal measurement assembly 3 are integrally designed, which achieves multi-channel sampling while reducing the structural dimensions, thereby facilitating miniaturization. Meanwhile, sampling is performed through the signal measurement assembly 3 without the need for a magnetic core, which, on the one hand, further reduces the structural dimensions, and on the other hand, avoids the risk of affecting sampling accuracy due to magnetic core saturation.

As shown in FIG. 6, embodiments of the present application provide a current sampling circuit, including:
at least one shunt sampling module, the shunt sampling module being disposed in correspondence with at least one signal conversion member 12 in the current sampling apparatus described above;
a signal sampling module, the signal sampling module corresponding to a signal measurement assembly 3 in the current sampling apparatus described above; and
a main control module, the main control module being configured to be separately connected to the at least one shunt sampling module and the signal sampling module.

In this embodiment, the current sampling circuit may include at least one shunt sampling module, where the at least one shunt sampling module may be disposed in correspondence with the at least one signal conversion member 12 in the current sampling apparatus; that is, the number of the shunt sampling module(s) is the same as the number of the signal conversion member(s) 12, and each shunt sampling module is electrically connected to the signal conversion member 12 corresponding to it.

For example, if the current sampling circuit includes one signal conversion member 12, the number of the corresponding shunt sampling module(s) is also one. The shunt sampling module may be configured for state description calculation and over current diagnosis of a battery pack. The state of X (SOX) of a battery pack may include a state of charge (SOC) of the power battery, a state of health (SOH) of the power battery, and a state of power (SOP) of the power battery.

The current sampling circuit may further include a signal sampling module, where the signal sampling module may correspond to the signal measurement assembly 3 in the current sampling apparatus. The signal sampling module may be configured for over current diagnosis and for verifying the sampled value of the shunt 1 sampling module. For example, in a case where the aforementioned signal measurement assembly 3 includes a Hall effect component, the aforementioned signal sampling module may include a Hall sampling module.

The main control module may include a central processing unit (CPU), which may be separately connected to the shunt 1 sampling module and the signal sampling module, and may be configured to receive electrical signals acquired by the shunt 1 sampling module and the signal sampling module and to analyze and process the electrical signals acquired by the shunt 1 sampling module and the signal sampling module, so as to obtain sampled currents corresponding to the shunt 1 sampling module and the signal sampling module.

It is understandable that the signal sampling module may include an output sub-module OUTPUT and an input voltage sub-module POWER, and the main control module may further include a low dropout regulator LDO, a first analog-to-digital conversion sub-module ADC 1, and a second analog-to-digital conversion sub-module ADC2. Here, the low dropout regulator LDO may output a stable input voltage to the input voltage sub-module POWER of the signal sampling module to ensure that the signal measurement assembly 3 can operate normally, where the input voltage may be set according to actual requirements, for example, the input voltage may be 5V. The electrical signals acquired by the signal sampling module may flow to the first analog-to-digital conversion sub-module ADC1 through the output sub-module OUTPUT and, after conversion, be received by the CPU. In addition, the electrical signals acquired by the shunt 1 sampling module may flow to the second analog-to-digital conversion sub-module ADC2 and, after conversion, be received by the CPU.

In this embodiment, the shunt 1 and the signal measurement assembly 3 are integrally designed, which achieves multi-channel sampling while reducing the structural dimensions, thereby facilitating miniaturization. Meanwhile, sampling is performed through the signal measurement assembly 3 without the need for a magnetic core, which, on the one hand, further reduces the structural dimensions, and on the other hand, avoids the risk of affecting sampling accuracy due to magnetic core saturation.

In some embodiments, the signal sampling module may further include a storage sub-module, the storage sub-module being configured to back up calibration data.

In this embodiment, the storage sub-module may be configured to back up calibration data. In other words, the calibration data corresponding to the signal measurement assembly 3 may be preconfigured and stored in the storage sub-module. Consequently, when the signal measurement assembly 3 is used for current sampling, the signal measurement assembly 3 can be directly calibrated based on the calibration data in the storage sub-module and then perform sampling, thereby further improving the sampling accuracy of the signal measurement assembly 3.

The aforementioned storage sub-module may be any structure with data storage functionality. Specifically, the storage sub-module may be an electrically erasable programmable read-only memory (EEPROM).

In some embodiments, the signal sampling module may further include a signal modulation sub-module, the signal modulation sub-module being configured to amplify and shape a voltage signal generated by the signal measurement assembly 3.

In this embodiment, the signal modulation sub-module may be configured to amplify and shape the voltage signal generated by the signal measurement assembly 3; the amplified and shaped voltage signal is transmitted to the main control module, such that the main control module can obtain a more accurate voltage signal, and then perform analysis and processing based on this voltage signal, thereby more accurately obtaining the sampled current corresponding to the signal measurement assembly 3, further improving the sampling accuracy of the signal measurement assembly 3.

In some embodiments, the signal sampling module may further include an over current detect (OCD) sub-module, and the OCD sub-module is configured to detect whether the current signal sampled by the signal sampling module is an over current.

In this embodiment, the OCD sub-module can effectively detect whether there is an over current risk. As an example, the main control module may further include a general-purpose input/output (GPIO) port; in a case where the sampled current corresponding to the signal measurement assembly 3 is greater than a current threshold, the OCD is triggered, and at this time, an OCD pin can output a low-level signal to the general-purpose input/output (GPIO) port, such that the CPU can receive this low-level signal, serving the purpose of an alarm.

By utilizing the over current diagnosis of the shunt 1, the over current diagnosis of the signal measurement assembly 3, and the OCD alarm inside the signal measurement assembly 3 to jointly detect the current of the battery 101, the robustness of the entire current detection is improved, the risk of missed reports and false reports is reduced, and consequently, the risk of thermal runaway of the battery pack can be reduced.

Embodiments of the present application provide a vehicle, including the aforementioned current sampling system or the aforementioned current sampling circuit.

Embodiments of the present application further provide a vehicle, and the vehicle may include the aforementioned current sampling system or the aforementioned current sampling circuit. In this way, since the current detection of the battery management system is more accurate and the reliability is higher, the reliability of the charging and discharging process of the vehicle can be improved, thereby reducing the risk of battery failures.

Although the present application has been described with reference to the preferred embodiments, various improvements can be made thereto and components thereof can be replaced with equivalents without departing from the scope of the present application. In particular, the technical features mentioned in the various embodiments can be combined in any manner as long as there is no structural conflict. The present application is not limited to the specific embodiments disclosed herein, but rather includes all technical solutions falling within the scope of the claims.

## Claims

1. A current sampling apparatus, comprising:
a shunt comprising a plurality of conductive connection members and at least one signal conversion member, wherein the plurality of conductive connection members are arranged sequentially, and the at least one signal conversion member is disposed in at least one conductive connection member group, the conductive connection member group comprising two adjacent conductive connection members;
a circuit board disposed on one side surface of the shunt, and the at least one signal conversion member being connected to the circuit board; and
a signal measurement assembly disposed on any one of the plurality of conductive connection members, and the signal measurement assembly being connected to the circuit board, wherein the signal measurement assembly is provided with a positive electrode sampling point and a negative electrode sampling point, the positive electrode sampling point and the negative electrode sampling point being disposed on side surfaces of the conductive connection member, respectively.

2. The current sampling apparatus according to claim 1, wherein the positive electrode sampling point and the negative electrode sampling point are disposed on two opposite side surfaces of the conductive connection member, respectively.

3. The current sampling apparatus according to claim 1, wherein the plurality of conductive connection members are disposed spaced apart from each other, and the signal conversion member is located within at least a portion of a spacing between two adjacent ones of the conductive connection members.

4. The current sampling apparatus according to claim 1, wherein the signal conversion member is disposed between every two adjacent ones of the conductive connection members.

5. The current sampling apparatus according to any one of claims 1 to 4, wherein the circuit board comprises:
a first sub-circuit board connected to the at least one signal conversion member; and
a second sub-circuit board electrically connected to the first sub-circuit board and connected to the signal measurement assembly.

6. The current sampling apparatus according to any one of claims 1 to 4, wherein at least one side surface of the conductive connection member provided with the signal measurement assembly is provided with a notch, and the position of the notch corresponds to the position of the signal measurement assembly.

7. The current sampling apparatus according to claim 6, wherein the notch covers a projection of the signal measurement assembly on the side surface of the conductive connection member that is provided with the notch.

8. The current sampling apparatus according to any one of claims 1 to 4, further comprising:
at least one temperature sensor disposed in correspondence with the at least one signal conversion member, the at least one temperature sensor being connected to the circuit board.

9. The current sampling apparatus according to any one of claims 1 to 4, wherein the circuit board is provided with a signal transmission member, the signal transmission member being electrically connected to the shunt and the signal measurement assembly, and the signal transmission member being configured to transmit electrical signals generated on the shunt and the signal measurement assembly.

10. The current sampling apparatus according to any one of claims 1 to 4, further comprising:
a calibration identifier disposed on the circuit board.

11. The current sampling apparatus according to any one of claims 1 to 4, wherein the signal measurement assembly comprises at least one of a Hall effect component, a shunt component, or a magnetoresistive effect component.

12. A current sampling system, comprising:
a battery and a sampling board;
and the current sampling apparatus according to any one of claims 1 to 11;
wherein the battery and the sampling board are separately connected to the current sampling apparatus.

13. A current sampling circuit, comprising:
at least one shunt sampling module disposed in correspondence with at least one signal conversion member in the current sampling apparatus according to any one of claims 1 to 11;
a signal sampling module corresponding to a signal measurement assembly in the current sampling apparatus according to any one of claims 1 to 11; and
a main control module configured to be separately connected to the at least one shunt sampling module and the signal sampling module.

14. The current sampling circuit according to claim 13, wherein the signal sampling module comprises a storage sub-module configured to back up calibration data.

15. The current sampling circuit according to claim 13, wherein the signal sampling module further comprises a signal modulation sub-module configured to amplify and shape a voltage signal generated by the signal measurement assembly.

16. The current sampling circuit according to any one of claims 13 to 15, wherein the signal sampling module further comprises an over current detection sub-module configured to perform over current detection on a current signal sampled by the signal sampling module.

17. A vehicle, comprising the current sampling system according to claim 12 or the current sampling circuit according to claim 13.
